# EUROPEAN PATENT APPLICATION

(11) **EP 4 242 279 A1**
(43) Date of publication of application: **13.09.2023**
(21) Application number: 21889024.2
(22) Date of filing: 20.10.2021
(51) Int. Cl.: C09J 133/04, C09J 175/04, C09J 201/02, H01L 21/301, C09J 7/38

(54) **PRESSURE-SENSITIVE ADHESIVE TAPE AND PROCESSING METHOD**

(30) Priority: 09.11.2020 JP 2020186379
(71) Applicant: Denka Company Limited, Tokyo 103-8338 (JP)
(72) Inventor: NAKAMURA, Chie, Tokyo 103-8338 (JP); TANAKA, Tomoaki, Tokyo 103-8338 (JP); TOKUI, Sota, Tokyo 103-8338 (JP); HASUMI, Mizuki, Tokyo 103-8338 (JP)
(74) Representative: Zacco Sweden AB
(86) International application number: PCT/JP2021/038723
(87) International publication number: WO 2022/097471

(57) **Abstract**

Provided is an adhesive tape having a base material layer and an adhesive layer disposed on the base material layer, wherein the adhesive layer contains a radical photoinitiator and polymer A having polymerizable carbon double bonds, and difference |R₀ - R₁| between contact angle R₀ of silicon wafer surface with respect to water and contact angle R₁ of the silicon wafer surface with respect to water after the adhesive layer is attached to the silicon wafer, left to stand for 24 hours, then irradiated with ultraviolet ray, and peeled, is 20° or less.

## Description

### Technical Field

The present invention relates to an adhesive tape and a processing method.

### Background Art

When a semiconductor package, a semiconductor wafer (hereinafter, also referred to as an "adherend"), or the like is singulated, a tape for semiconductor wafer processing is attached to the adherend and the adherend is temporarily fixed during dicing. This can prevent chip flying during singulation. After dicing, the tape for semiconductor wafer processing is expanded, and the singulated adherend is picked up (peeled) from the tape for semiconductor wafer processing.

An adhesive tape in which a film base material having permeability to ultraviolet ray is coated with an adhesive layer that causes curing reaction by ultraviolet irradiation is typically used as such a tape for semiconductor wafer processing. This ultraviolet curable tape for processing can reduce the adhesive strength of the adhesive layer as curing reaction is allowed to proceed by the ultraviolet irradiation of the adhesive layer after dicing. Therefore, the singulated adherend can be easily picked up.

For such a tape for semiconductor wafer processing, a technique is demanded which can reduce glue residue on the adherend at the time of pick-up and produce a high-quality electronic component.

In this respect, in the ultraviolet irradiation type tape for processing mentioned above, if air bubbles, etc. enter the gap between the adhesive tape and the adherend in attaching the adhesive tape to the adherend, poor curing of the adhesive is caused due to oxygen inhibition or the like during ultraviolet irradiation. Thus, the adhesive may remain uncured on the adherend. If adhesive strength to the adherend is insufficient, cutting water enters the gap between the adherend and the adhesive tape during dicing and thereby contaminates the adherend and further, the singulated adherend flies.

Accordingly, a possible method for compensating for adhesive strength involves increasing the thickness of the adhesive layer, or enhancing adhesive strength by decreasing the modulus of elasticity of the adhesive layer. In this case, however, the adhesive is melted by frictional heat resulting from blade rotation during dicing so that the adhesive scraps may adhere to the adherend by scraping up the adhesive. Also, the singulated adherend is fixed to the adhesive tape so that failure may occur in the adhesive itself at the time of pick-up because the adhesive cannot be peeled at its interface with the adherend. Thus, the adhesive scraps disadvantageously remain on the adherend.

By contrast, for example, Patent Literature 1 discloses that glue residue is suppressed by using a radiation polymerizable compound having 5 or 6 acryloyl groups, and setting a gel fraction after ultraviolet irradiation and/or electron beam irradiation to 90 wt% or more, etc.

### Citation List

### Patent Literature

Patent Literature 1: Japanese Patent Laid-Open No. 2000-281993

### Summary of Invention

### Technical Problem

However, the method described in Patent Literature 1 tends to rather reduce adhesive strength, though being able to suppress glue residue to a certain extent. Thus, cutting water may enter the gap between the adherend and the adhesive tape during dicing and thereby contaminates the back side and, the singulated adherend may fly.

From recent request for the densification or sophistication of semiconductor wafers or devices, even semiconductor wafer or device surface that seems free from glue residue of an adhesive may be contaminated by organic matter attributed to the adhesive, and such contamination becomes a growing problem. In the present specification, the mere term "contamination" refers to such contamination that cannot be visually observed, and a contaminant that can be visually observed is referred to as "glue residue".

The present invention has been made in light of the problems described above. An object of the present invention is to provide an adhesive tape that can reduce contamination derived from an adhesive layer, and a processing method using the same.

### Solution to Problem

The present inventors have conducted diligent studies on the adhesive design of an adhesive tape in order to attain the object. As a result, the present inventors have completed the present invention by finding that the object can be attained by using an adhesive layer configured to exhibit predetermined contact angle characteristics before and after ultraviolet curing.

Specifically, the adhesive tape according to the present invention is as follows.
[1] An adhesive tape comprising
   a base material layer and an adhesive layer disposed on the base material layer, wherein
   the adhesive layer comprises a radical photoinitiator and a polymer A having a polymerizable carbon double bond, and
   difference |R₀ - R₁| between contact angle R₀ of silicon wafer surface with respect to water and contact angle R₁ of the silicon wafer surface with respect to water after the adhesive layer is attached to the silicon wafer, left to stand for 24 hours, then irradiated with ultraviolet ray, and peeled, is 20° or less.
[2] The adhesive tape according to [1], wherein
   a content of component A1 having a weight-average molecular weight of 20000 or lower contained in the polymer A is 15 area% or less based on the total area of a chart of gel permeation chromatography.
[3] The adhesive tape according to [1] or [2], wherein
   180° peel strength of the adhesive layer to a silicon wafer before ultraviolet irradiation is 2.0 to 20.0 N/20 mm at 23°C.
[4] The adhesive tape according to any one of [1] to [3], wherein
   the polymer A has a hydroxy group.
[5] The adhesive tape according to any one of [1] to [4], wherein
   a weight-average molecular weight of the polymer A is 1.0 × 10⁵ to 2.0 × 10⁶.
[6] The adhesive tape according to any one of [1] to [5], wherein
   a glass transition temperature of the polymer A is - 80 to 23°C.
[7] The adhesive tape according to any one of [1] to [6], wherein
   the polymer A comprises a (meth)acrylic acid ester copolymer, and
   the (meth)acrylic acid ester copolymer has a linear shape, a branched shape, or a cross-linked shape.
[8] The adhesive tape according to any one of [1] to [7], wherein
   the adhesive layer further comprises a curing agent.
[9] The adhesive tape according to [8], wherein
   the curing agent comprises an isocyanate compound.
[10] The adhesive tape according to [9], wherein
   the isocyanate compound comprises a difunctional or higher polyfunctional isocyanate compound.
[11] The adhesive tape according to any one of [8] to [10], wherein
   a content of the curing agent is 0.1 to 5.0 parts by weight per 100 parts by weight of the polymer A.
[12] The adhesive tape according to any one of [1] to [11]
   for processing of a semiconductor wafer, a semiconductor device, or various semiconductor packages.
[13] A processing method comprising:
   a lamination step of laminating an adhesive tape according any one of [1] to [12] with an adherend; and
   a dicing step of singulating the adherend in a laminated state of the adhesive tape and the adherend, wherein
   the adherend is a semiconductor wafer, a semiconductor device or various semiconductor packages.

### Advantageous Effects of Invention

The present invention can provide an adhesive tape that can reduce contamination derived from an adhesive layer, and a processing method using the same.

### Description of Embodiments

Hereinafter, the mode for carrying out the present invention (hereinafter, referred to as the "present embodiment") will be described in detail. However, the present invention is not limited thereby, and various changes or modifications can be made without departing from the spirit of the present invention.

### [Adhesive tape]

The adhesive tape of the present embodiment comprises a base material layer and an adhesive layer disposed on the base material layer, wherein the adhesive layer comprises a radical photoinitiator and polymer A having polymerizable carbon double bonds, and difference |R₀ - R₁| between contact angle R₀ of silicon wafer surface with respect to water and contact angle R₁ of the silicon wafer surface with respect to water after the adhesive layer is attached to the silicon wafer, left to stand for 24 hours, then irradiated with ultraviolet ray, and peeled, is 20° or less.

A conventional adhesive layer is constituted by, for example, a base polymer having no ultraviolet curability, and a low-molecular-weight component having ultraviolet curability. Hence, a low-molecular-weight component which remains in an unreacted state may contaminate adherend surface after ultraviolet irradiation.

By contrast, in the present embodiment, by use of polymer A having polymerizable carbon double bonds, one polymer A is further polymerized and cross-linked to another polymer A by ultraviolet irradiation. Hence, the problem of contamination of adherend surface by a low-molecular-weight component can be circumvented. Furthermore, if some polymerizable carbon double bonds of the polymer A are unreacted, the contamination of adherend surface can also be circumvented as compared with a low-molecular-weight component. In the case of using a low-molecular-weight component having polymerizable carbon double bonds, the low-molecular-weight component also becomes capable of binding to the polymer A and therefore remains easily in the adhesive. This can prevent the low-molecular-weight component from contaminating adherend surface.

In the present embodiment, the curing characteristics of the adhesive layer comprising the polymer A by ultraviolet irradiation are further defined by contact angle characteristics represented by difference |R₀ - R₁| between contact angle R₀ and contact angle R₁. Use of the adhesive layer having such contact angle characteristics can further reduce contamination derived from the adhesive layer. Hereinafter, the present invention will be described in detail.

### (Contact angle)

In the present embodiment, low contaminating properties of the adhesive layer to a silicon wafer after ultraviolet irradiation are defined using difference |R₀ - R₁| between contact angle R₀ of silicon wafer surface with respect to water and contact angle R₁ of the silicon wafer surface with respect to water after the adhesive layer is attached to the silicon wafer, left to stand for 24 hours, then irradiated with ultraviolet ray, and peeled.

More specifically, the difference |R₀ - R₁| is 20° or less, preferably 0 to 17.5°, more preferably 0 to 15°, further preferably 0 to 12.5°. Smaller difference |R₀ - R₁| more reduces the contamination of an adherend.

Particularly, when |R₀ - R₁| is 20° or less, contaminating properties are more markedly reduced and yields in the subsequent production process or at the time of mounting of an adherend are also improved. On the other hand, if the difference |R₀ - R₁| is larger than 20°, adherend surface is easily contaminated and further, even glue residue on an adherend may occur.

Silicon wafer surface exposes its hydroxy groups to the outermost surface by oxidation with oxygen in air and therefore, is generally highly hydrophilic. Accordingly, small contact angle R₁ with respect to water means being close to the state of clean silicon wafer surface before attachment of the adhesive tape. On the contrary, the contamination of a silicon wafer by an organic component contained in the adhesive layer reduces the hydrophilicity of silicon wafer surface and increases a contact angle with respect to water.

The contact angle R₁ is preferably 5 to 25°, more preferably 5 to 28°, further preferably 5 to 32°. When the contact angle R₁ falls within the range described above, the contamination of a silicon wafer by the adhesive layer after ultraviolet irradiation is more suppressed.

Examples of the method for adjusting the difference |R₀ - R₁| and the contact angle R₁ to the ranges described above include, but are not particularly limited to, decrease in the amount of a low-molecular-weight component contained in the adhesive layer, decrease in the amount of the low-molecular-weight component in the polymer A, and elevation of a cross-link density during ultraviolet irradiation. Examples of the method for decreasing the amount of a low-molecular-weight component include, but are not particularly limited to, methods of forming an adhesive layer on a base material layer, followed by aging under heating, and use of polymer A having a small content of a low-molecular-weight component. Examples of the method for elevating a cross-link density include, but are not particularly limited to, methods of adjusting the number of polymerizable carbon double bonds or the content of a radical photoinitiator.

The "contact angle" described in the present specification is a contact angle determined by attaching the adhesive tape to a silicon wafer, leaving the resultant to stand under a condition of 23°C for 24 hours, followed by ultraviolet irradiation at 150 mJ/cm² with a high-pressure mercury lamp, peeling, and the measurement of a contact angle with respect to water by a liquid droplet method.

### (180° peel strength)

The 180° peel strength S of the adhesive layer to a silicon wafer before ultraviolet irradiation is preferably 2.0 to 20.0 N/20 mm, more preferably 4.0 to 16.0 N/20 mm, further preferably 6.0 to 12.0 N/20 mm, at 23°C.

When the 180° peel strength S is 2.0 N/20 mm or more, adhesive strength before ultraviolet irradiation tends to be much better. Hence, the adhesive tape is unlikely to be detached from a ring frame, and chip flying is unlikely to occur in a dicing step.

When the 180° peel strength S is 20 N/20 mm or less, the adhesive is unlikely to be scraped up by a blade in a dicing step. Thus, the scraped-up adhesive tends to be unlikely to adhere to the side, etc. of an adherend. This tends to more prevent a phenomenon in which the scraped-up adhesive remains as glue residue on the adherend or is ultraviolet-cured as it is to fix a chip, causing poor pick-up, and the fixed chip cracks.

The "180° peel strength to a silicon wafer" described in the present specification can be measured in accordance with a method for measuring adhesive strength in JIS Z 0237 (2009). Specifically, the adhesive layer is pressure-bonded to an adherend (silicon wafer) having a washed surface using a pressure bonding apparatus (roller mass: 2 kg), and adhesive strength upon peeling by 180° relative to the adherend is measured with a universal tensile tester in an environment having a temperature of 23°C and a humidity of 50%.

### (Adhesive layer)

The adhesive layer comprises a radical photoinitiator and polymer A having polymerizable carbon double bonds and may optionally comprise a curing agent and other components.

### (Polymer A)

The polymer A is a polymer having polymerizable carbon double bonds and is a component that constitutes a main component of the adhesive layer. When the adhesive layer is irradiated with ultraviolet ray, the radical photoinitiator generates a radical. The polymerizable carbon double bonds of one polymer A are polymerized with those of another polymer A. As a result, these polymers A become a state cross-linked to each other after ultraviolet irradiation.

A small amount of a low-molecular-weight component contained in the polymer A is preferred from the viewpoint of reduction in contamination. More specifically, the content of component A1 having a weight-average molecular weight of 20000 or lower contained in the polymer A is preferably 15 area% or less, more preferably 10 area% or less, further preferably 8 area% or less, still further preferably 5 area% or less, based on the total area of a chart of gel permeation chromatography. The lower limit of the content of the component A1 is not particularly limited and is 0 area%. When the content of the component A1 is 15 area% or less, the amount of the low-molecular-weight component remaining on adherend surface after ultraviolet irradiation is reduced. Thus, contamination tends to be more reduced.

The weight-average molecular weight of the polymer A is preferably 1.0 × 10⁵ to 2.0 × 10⁶, more preferably 2.0 × 10⁵ to 1.0 × 10⁶, further preferably 2.5 × 10⁵ to 8.0 × 10⁵. When the weight-average molecular weight of the polymer A is 1.0 × 10⁵ or higher, the amount of a high-molecular-weight component is increased. In addition, a higher molecular weight increases a chance that one polymer A is polymerized with another polymer A through the polymerizable double bonds, and therefore tends to more reduce contamination. When the weight-average molecular weight of the polymer A is 2.0 × 10⁶ or lower, polymer A has mobility, which increases a chance that one polymer A is polymerized with another polymer A, and therefore tends to more reduce contamination. A smaller molecular weight prevents the adhesive from having too high a modulus of elasticity and therefore tends to more improve adhesive strength in an ordinary state. Since the adhesive has good following properties to an adherend and can follow the steps of the adherend, contamination ascribable to poor UV curing caused by oxygen inhibition can be avoided. A soft adhesive is sufficiently susceptible to cure shrinkage by UV irradiation. Therefore, adhesive strength after curing can be sufficiently reduced.

The "weight-average molecular weight" described in the present specification is a molecular weight determined by measuring a sample of the polymer A dissolved in tetrahydrofuran using a gel permeation chromatograph analysis apparatus. The content of component A1 can be determined by calculating the ratio of its area in a chromatogram at a retention time when the weight-average molecular weight reaches 20000 or lower, from a calibration curve of molecular weights based on standard polystyrene with the area of the polymer A in a chromatogram defined as 100 area%.

The glass transition temperature of the polymer A is preferably -80 to 23°C, more preferably -70 to 10°C, further preferably -60 to 0°C. When the glass transition temperature of the polymer A is -80°C or higher, contamination tends to be more reduced. When the glass transition temperature of the polymer A is 23°C or lower, adhesiveness to an adherend tends to be more improved.

Examples of the polymer A include, but are not particularly limited to, (meth)acrylic acid ester copolymers having polymerizable double bonds. Examples of the shape of the (meth)acrylic acid ester copolymer include, but are not particularly limited to, linear shapes, branched shapes, and cross-linked shapes. The polymer A preferably has a cross-linked shape among them. Use of such polymer A improves the cohesion of the adhesive layer and more improves adhesiveness to an adherend while contamination tends to be more reduced. The polymer A having a cross-linked shape or a branched shape may be derived from the polymer A having a linear shape through the binding of some polymerizable double bonds by aging or the like.

Examples of the(meth)acrylic acid ester monomer constituting the (meth)acrylic acid ester copolymer include, but are not particularly limited to, alkyl (meth)acrylate having a linear or branched alkyl group such as a methyl group, an ethyl group, a n-propyl group, an isopropyl group, a n-butyl group, a t-butyl group, an isobutyl group, an amyl group, an isoamyl group, a hexyl group, a heptyl group, a cyclohexyl group, a 2-ethylhexyl group, an octyl group, an isooctyl group, a nonyl group, an isononyl group, a decyl group, an isodecyl group, an undecyl group, a lauryl group, a tridecyl group, a tetradecyl group, a stearyl group, an octadecyl group, and a dodecyl group. One of these alkyl (meth)acrylates may be used alone, or two or more types thereof may be used in combination.

Examples of the monomer component other than the alkyl (meth)acrylate include, but are not particularly limited to: carboxyl group-containing monomers such as acrylic acid, methacrylic acid, carboxyethyl (meth)acrylate, carboxypentyl (meth)acrylate, itaconic acid, maleic acid, fumaric acid, and crotonic acid; acid anhydride monomers such as maleic anhydride and itaconic anhydride; hydroxyl group-containing monomers such as 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 1-hydroxydecyl (meth)acrylate, 12-hydroxylauryl (meth)acrylate, and (4-hydroxymethylcyclohexyl)methyl (meth)acrylate; alkyleneoxy group-containing monomers such as ethoxyethoxyethyl (meth)acrylate; sulfonic acid group-containing monomers such as styrenesulfonic acid, allylsulfonic acid, 2-(met)acrylamido-2-methylpropanesulfonic acid, (meth)acrylamidopropanesulfonic acid, sulfopropyl (meth)acrylate, and (meth)acryloyloxynaphthalenesulfonic acid; and phosphoric acid group-containing monomers such as 2-hydroxyethylacryloyl phosphate. One of these additional monomers may be used alone, or two or more types thereof may be used in combination.

Among them, a (meth)acrylic acid ester copolymer comprising alkyl (meth)acrylate and a hydroxyl group-containing monomer or a (meth)acrylic acid ester copolymer comprising alkyl (meth)acrylate and a carboxyl group-containing monomer is preferred.

Examples of the method for introducing the polymerizable double bonds to the (meth)acrylic acid ester copolymer include, but are not particularly limited to, methods of reacting a modifying agent having the polymerizable double bonds with the carboxyl group of a carboxyl group-containing monomer, the anhydrous carboxyl group of an acid anhydride monomer, or the hydroxyl group of a hydroxyl group-containing monomer.

For example, an isocyanate compound having the polymerizable double bonds can be reacted as a modifying agent with a (meth)acrylic acid ester copolymer comprising a hydroxyl group-containing monomer unit to introduce the polymerizable double bonds to the hydroxyl group-containing monomer unit via urethane bonds. As another example, an epoxy compound having the polymerizable double bonds can be reacted as a modifying agent with a (meth)acrylic acid ester copolymer comprising a hydroxyl group-containing monomer unit to introduce the polymerizable double bonds to the hydroxyl group-containing monomer unit via ether bonds.

The modifying agent is not particularly limited as long as the modifying agent has a functional group reactive with a functional group carried by the (meth)acrylic acid ester copolymer and has the polymerizable double bonds. Examples thereof include isocyanate compounds having the polymerizable double bonds, and epoxy compounds having the polymerizable double bonds.

The amount of the polymerizable double bonds introduced is preferably 20 to 80% by mol, more preferably 30 to 75% by mol, further preferably 40 to 70% by mol, per 100% by mol of reactive monomer units constituting the polymer A. In this context, the "reactive monomer units" refer to a carboxyl group-containing monomer, an acid anhydride monomer, and a hydroxyl group-containing monomer. When the amount of the polymerizable double bonds introduced is 20% by mol or more, unreacted polymer A is unlikely to remain during ultraviolet irradiation. Thus, contamination tends to be more suppressed. When the amount of the polymerizable double bonds introduced is 80% by mol or less, excessive cross-linking can be suppressed. This tends to prevent a phenomenon in which the adhesive layer cannot stand the deformation of the adhesive tape ascribable to the push-up of a pin at the time of pick-up and cracks in the shape of a pin, and thereby causes glue residue. When the amount of the polymerizable double bonds introduced is 80% by mol or less, a polar group such as an unreacted carboxyl group remains easily. Thus, adhesive strength to an adherend before ultraviolet irradiation tends to be more improved.

The polymer A preferably has a hydroxy group. The hydroxy group may be derived from a hydroxyl group-containing monomer or the like, may be a hydroxy group derived from a modifying agent, or may be a hydroxy group resulting from the reaction of a hydroxyl group-containing monomer with a modifying agent. Examples of the hydroxy group resulting from the reaction of a monomer unit such as a hydroxyl group-containing monomer with a modifying agent include cases of reacting an epoxy compound having the polymerizable double bonds with a hydroxyl group-containing monomer.

By use of the polymer A having a hydroxy group, a plurality of polymers can be further cross-linked via the hydroxy group when blended with the curing agent mentioned later. Thus, the cohesion of the adhesive layer tends to be more improved. Also, the anchoring properties between a base material film and the adhesive layer are more improved, and cohesive failure and anchor failure are suppressed. Thus, more stable adhesive characteristics tend to be obtained.

The content of the polymer A is preferably 80 to 99.5% by mass, more preferably 85 to 99.5% by mass, further preferably 90 to 99.5% by mass, based on the total amount of the adhesive layer. When the content of the polymer A falls within the range described above, contamination tends to be more reduced.

### (Radical photoinitiator)

Examples of the radical photoinitiator include, but are not particularly limited to, alkylphenone photopolymerization initiators, acylphosphine oxide photopolymerization initiators, thioxanthone photopolymerization initiators, aromatic ketones, aromatic onium salt compounds, organic peroxides, thio compounds (thiophenyl group-containing compounds, etc.), α-aminoalkylphenone compounds, hexaarylbiimidazole compounds, ketoxime ester compounds, borate compounds, azinium compounds, metallocene compounds, active ester compounds, compounds having a carbon halogen bond, and alkylamine compounds.

Among them, an alkylphenone photopolymerization initiator is preferred.

The content of the radical photoinitiator is preferably 0.1 to 5.0% by mass, more preferably 0.2 to 4.0% by mass, further preferably 0.3 to 3.0% by mass, based on the total amount of the adhesive layer. When the content of the radical photoinitiator falls within the range described above, contamination tends to be more reduced.

### (Curing agent)

Examples of the curing agent can include, but are not particularly limited to, isocyanate compounds, epoxy compounds, and amine compounds. Among them, an isocyanate compound is preferred. By use of such a curing agent, the cohesion of the adhesive layer tends to be more improved. One of these curing agents may be used alone, or two or more thereof may be used in combination.

Examples of the isocyanate compound include, but are not particularly limited to: aromatic diisocyanate such as tolylene diisocyanate, 4,4-diphenylmethane diisocyanate, and xylylene diisocyanate; alicyclic diisocyanate such as isophorone diisocyanate and methylenebis(4-cyclohexyl isocyanate); and aliphatic diisocyanate such as hexamethylene diisocyanate and trimethylhexamethylene diisocyanate. One of these isocyanate compounds may be used alone, or two or more thereof may be used in combination.

Among them, the curing agent is preferably a difunctional or higher polyfunctional isocyanate compound. By use of such a curing agent, a plurality of polymers A can be cross-linked by the curing agent. Therefore, the cohesion of the adhesive layer tends to be more improved. Also, the anchoring properties between a base material film and the adhesive layer are improved. Thus, more stable adhesive characteristics tend to be obtained.

The content of the curing agent is preferably 0.1 to 5.0 parts by weight, more preferably 0.3 to 4.0 parts by weight, further preferably 0.3 to 3.0 parts by weight, per 100 parts by weight of the polymer A. When the content of the curing agent is 0.1 parts by weight or more, the cross-link density of the adhesive layer is more improved and cohesive failure resulting from peeling is more suppressed. Thus, contamination caused by cohesive failure tends to be more reduced. When the content of the curing agent is 5.0 parts by weight or less, the cross-link density is more reduced and the modulus of elasticity is decreased. Therefore, adhesive strength tends to be more improved.

The content of the curing agent is preferably 0.1 to 2.0% by mass, more preferably 0.2 to 1.5% by mass, further preferably 0.3 to 1.0% by mass, based on the total amount of the adhesive layer. When the content of the curing agent falls within the range described above, contamination tends to be more reduced.

### (Other additives)

The adhesive layer of the present embodiment may contain, if necessary, other additives such as a tackifier, a cross-linking retarder, and an antioxidant.

Examples of the tackifier include, but are not particularly limited to, petroleum resin, terpene resin, terpene phenol resin, aromatic modified terpene resin, chromane-indene resin, natural resin rosin, modified rosin, glycerin ester rosin, pentaerythritol ester rosin, phenol resin, xylene resin, alicyclic petroleum resin, styrene resin, and dicyclopentadiene resin.

The cross-linking retarder is not particularly limited and is, for example, a compound that can suppress excessive elevation in viscosity of an adhesive composition containing an isocyanate curing agent by blocking an isocyanate group carried by the curing agent in the adhesive composition. Examples of such a cross-linking retarder include, but are not particularly limited to: β-diketones such as acetylacetone, hexane-2,4-dione, heptane-2,4-dione, and octane-2,4-dione; β-ketoesters such as methyl acetoacetate, ethyl acetoacetate, propyl acetoacetate, butyl acetoacetate, octyl acetoacetate, oleyl acetoacetate, lauryl acetoacetate, and stearyl acetoacetate; and benzoyl acetone.

Examples of the antioxidant include, but are not particularly limited to, methylhydroquinone, hydroquinone, 2,2-methylene-bis(4-methyl-6-tertiary butylphenol), catechol, hydroquinone monomethyl ether, mono-tertiary butylhydroquinone, 2,5-di-tertiary butylhydroquinone, p-benzoquinone, 2,5-diphenyl-p-benzoquinone, 2,5-di-tertiary butyl-p-benzoquinone, picric acid, citric acid, phenothiazine, tertiary butyl catechol, 2-butyl-4-hydroxyanisol, 2,6-di-tertiary butyl-p-cresol, and 4-[[4,6-bis(octylthio)-1,3,5-triazin-2-yl]amino]-2,6-di-tertiary butylphenol.

### (Thickness)

The thickness of the adhesive layer is usually 1.0 to 250 µm, preferably 2.0 to 50 µm, further preferably 5.0 to 40 µm. When the thickness of the adhesive layer is 1.0 µm or larger, sufficient adhesive strength can be secured. Therefore, semiconductor chips divided by expanding are easily prevented from flying. When the thickness of the adhesive layer is 250 µm or smaller, cost tends to be more reduced.

For use as a tape for semiconductor wafer processing, the thicknesses of the base material layer and the adhesive layer are preferably adjusted within the ranges described above such that the total thickness of the tape is preferably in the range of 60 to 250 µm. The thickness of the tape for semiconductor wafer processing is in the range of more preferably 70 to 200 µm, further preferably 80 to 180 µm.

### (Base material layer)

Examples of the material constituting the base material layer include, but are not particularly limited to, polyvinyl chloride, polyethylene terephthalate, ethylene-vinyl acetate copolymers, ethylene-acrylic acid-acrylic acid ester films, ethylene-ethyl acrylate copolymers, polyethylene, polypropylene, propylene copolymers, ethylene-acrylic acid copolymers, and ionomer resin in which ethylene-(meth)acrylic acid copolymers, ethylene-(meth)acrylic acid-(meth)acrylic acid ester copolymers, or the like are cross-linked through metal ions. The base material film constituting the base material layer may be such a resin used singly, a mixture or a copolymer of two or more of these resins, or a laminate thereof.

The thickness of the base material layer can be appropriately selected without impairing workability. The thickness of the base material layer is usually 10 to 500 µm, preferably 50 to 200 µm, further preferably 70 to 150 µm. When the thickness of the base material layer is adjusted to within the range described above, the resulting base material layer is free from practical problems and economically effective. When the base material layer is constituted by a plurality of base material films, the thickness of the whole base material layer is preferably adjusted so as to fall within the range described above.

The base material layer may be surface-treated chemically or physically, if necessary, in order to improve its tight contact with the adhesive layer. Examples of the surface treatment include corona treatment, chromic acid treatment, ozone exposure, flame exposure, high-voltage electric shock exposure, and ionization radiation treatment.

### (Protective film)

The adhesive tape of the present embodiment may have a protective film laminated onto the adhesive layer in order to protect the adhesive layer. The protective film is peeled when the adhesive tape is used. Therefore, an excellently peelable film is preferred. Examples of the protective film include, but are not particularly limited to, films that are made of fluorine resin and have low surface energy, and films of polyethylene terephthalate having a surface treated with a silicone release agent.

### (Purpose)

The adhesive tape of the present embodiment can be suitably used for the purpose of processing a semiconductor wafer, a semiconductor device, or various semiconductor packages. The semiconductor wafer may be an unsingulated semiconductor wafer with an electronic circuit or the like formed thereon. The semiconductor device refers to various singulated semiconductor chips or an element comprising these chips. The semiconductor package refers to an article having a semiconductor chip, a resin for protection thereof, and a connection terminal which connects the semiconductor chip to the outside.

### [Method for producing adhesive tape]

Examples of the method for producing the adhesive tape include, but are not particularly limited to, methods of forming an adhesive layer on a base material layer.

The base material layer of the adhesive tape of the present embodiment can be produced in accordance with a well-known technique. The approach of forming the base material layer is not particularly limited. The various materials described above are mixed by routine melt kneading or the like or using various mixing apparatuses (single-screw or twin-screw extruders, rolls, Banbury mixers, various kneaders, etc.) such that the respective components are uniformly dispersed. The mixture is molded into a base material by a T-die method, a calendar method, or an inflation method. A method of forming a film by a T-die method using an extruder having good thickness precision is preferred.

The adhesive layer of the adhesive tape of the present embodiment can be produced in accordance with a well-known technique. The approach of forming the adhesive layer is not particularly limited. The various materials described above are dissolved in a solvent such as an organic solvent to prepare a varnish, with which a protective film is then coated by a knife coating method, a roll coating method, a spray coating method, a gravure coating method, a bar coating method, or a curtain coating method, etc. The solvent is removed to form an adhesive layer. This layer is laminated onto the base material layer to prepare an adhesive tape.

In the present embodiment, the adhesive layer thus formed may be subjected to aging treatment. In the aging treatment, the formed adhesive layer is stored at a predetermined temperature. The temperature condition is not particularly limited and is preferably 30 to 50°C, more preferably 35 to 45°C. The storage time is not particularly limited and is preferably 24 to 150 hours, more preferably 48 to 100 hours. This aging treatment performed changes the adhesive strength or curing characteristics of the adhesive layer. Also, the tensile modulus of elasticity and the elongation at break after ultraviolet irradiation can be controlled to the preferred ranges described above.

### [Processing method]

The processing method of the present embodiment is a method comprising: a lamination step of laminating the adhesive tape described above with an adherend; and a dicing step of processing the adherend in a laminated state of the adhesive tape and the adherend, wherein a semiconductor wafer, a semiconductor device or various semiconductor packages are processed as the adherend. The processing method of the present embodiment may optionally have an ultraviolet irradiation step of irradiating the adhesive tape with ultraviolet ray after the dicing step, or a pick-up step of picking up singulated chips from the adhesive tape after ultraviolet irradiation.

The singulation method in the dicing step is not particularly limited, and a conventional method known in the art can be used. For example, a silicon wafer can be cut into semiconductor chips by the high-speed rotation of a dicing blade containing diamond abrasive grains using a dicing apparatus.

The ultraviolet irradiation method is not particularly limited, and a conventional method known in the art can be used. For example, the adhesive tape in the dicing step is irradiated with ultraviolet ray using an ultraviolet irradiation apparatus.

Then, the pick-up method is not particularly limited, and a conventional method known in the art can be used. For example, the adhesive tape after ultraviolet irradiation is drawn along the direction of the surface using an expanding apparatus, and the chips can be picked up in a separated state of the chips using a pick-up apparatus.

### Examples

Hereinafter, the present invention will be described more specifically with reference to Examples and Comparative Examples. However, the present invention is not limited by these examples.

### (Example 1)

63 parts by weight of 2-ethylhexyl acrylate, 15 parts by weight of 2-hydroxyethyl acrylate, 22 parts by weight of ethoxyethoxyethyl acrylate, and 0.03 parts by weight of an initiator (azobisisobutyronitrile) were copolymerized at 65°C for 24 hours in ethyl acetate to obtain a solution containing an acrylic polymer.

2-Methacryloyloxyethyl isocyanate was reacted with the hydroxy group of the 2-hydroxyethyl acrylate unit in the acrylic polymer to obtain a side-chain double bond introduction type acrylic polymer having double bonds introduced to side chains. In this operation, both the materials were reacted such that the amount of 2-methacryloyloxyethyl isocyanate introduced was 50 mol (50% by mol) per 100 mol of the 2-hydroxyethyl acrylate unit in the acrylic polymer.

Subsequently, 0.5 parts by weight of a trimethylolpropane-modified tolylene diisocyanate curing agent (Nippon Polyurethane Industry Co., Ltd.; CORONATE L-45E) as a polyisocyanate compound, and 2.1 parts by weight of 2,2-dimethoxy-2-phenylacetophenone (manufactured by BASF SE; Omnirad 651) (as a radical photoinitiator were added to the solution containing 100 parts by weight of the side-chain double bond introduction type acrylic polymer to prepare a resin composition serving as an ultraviolet curable adhesive.

A release-treated surface of a polyethylene terephthalate protective film subjected to release treatment in advance was coated with this resin composition such that the thickness of an adhesive layer after drying was 20 µm. The resultant was dried at 100°C for 1 minute and then laminated onto a corona-treated surface of an ionomer film (base material resin film) of an ethylene-methacrylic acid-acrylic acid ester copolymer whose surface to be laminated with the adhesive layer was subjected to corona treatment in advance. The adhesive was thereby transferred to the base material resin film. The resultant was aged in an atmosphere of 40°C for 72 hours to obtain an adhesive tape.

### (Example 2)

67 parts by weight of butyl acrylate, 28 parts by weight of methyl acrylate, 5 parts by weight of 2-hydroxyethyl acrylate, and 0.03 parts by weight of an initiator (azobisisobutyronitrile) were copolymerized at 65°C for 24 hours in toluene to obtain a solution containing an acrylic polymer. 2-Methacryloyloxyethyl isocyanate was reacted with the hydroxy group of the 2-hydroxyethyl acrylate unit in the acrylic polymer to obtain a side-chain double bond introduction type acrylic polymer having double bonds introduced to side chains. In this operation, both the materials were reacted such that the amount of 2-methacryloyloxyethyl isocyanate introduced was 70 mol (70% by mol) per 100 mol of the 2-hydroxyethyl acrylate unit in the acrylic polymer. The acrylic polymer was washed at a solid concentration of 20% in a solution of ethyl acetate:methanol = 1:20 to remove a low-molecular-weight component. The subsequent procedures were performed in the same manner as in Example 1 to obtain an adhesive tape.

### (Example 3)

An adhesive tape was obtained in the same manner as in Example 2 except that the step of washing the acrylic polymer was omitted.

### (Example 4)

An adhesive tape was obtained in the same manner as in Example 1 except that both the materials were reacted such that the amount of 2-methacryloyloxyethyl isocyanate introduced was 30 mol (30% by mol) per 100 mol of the 2-hydroxyethyl acrylate unit in the acrylic polymer.

### (Example 5)

An adhesive tape was obtained in the same manner as in Example 1 except that the weight-average molecular weight of the side-chain double bond introduction type acrylic polymer was adjusted to 800,000 by adjusting the amount of the initiator.

### (Example 6)

92 parts by weight of 2-ethylhexyl acrylate, 8 parts by weight of acrylic acid, and 0.05 parts by weight of an initiator (azobisisobutyronitrile) were copolymerized at 65°C for 24 hours in ethyl acetate to obtain a solution containing an acrylic polymer.

Glycidyl methacrylate was reacted with the carboxyl group of the acrylic acid unit in the acrylic polymer to obtain a side-chain double bond introduction type acrylic polymer having double bonds introduced to side chains. In this operation, both the materials were reacted such that the amount of glycidyl methacrylate introduced was 80 mol (80% by mol) per 100 mol of the acrylic acid unit in the acrylic polymer. The acrylic polymer was washed at a solid concentration of 20% in a solution of ethyl acetate:methanol = 1:20 to remove a low-molecular-weight component.

Subsequently, 0.1 parts by weight of a trimethylolpropane-modified tolylene diisocyanate curing agent (Nippon Polyurethane Industry Co., Ltd.; CORONATE L-45E) as a polyisocyanate compound, and 2.1 parts by weight of 2,2-dimethoxy-2-phenylacetophenone (manufactured by BASF SE; Omnirad 651) as a radical photoinitiator were added to the solution containing 100 parts by weight of the side-chain double bond introduction type acrylic polymer to prepare a resin composition serving as an ultraviolet curable adhesive. The subsequent procedures were performed in the same manner as in Example 1 to obtain an adhesive tape.

### (Example 7)

An adhesive tape was obtained in the same manner as in Example 6 except that: when glycidyl methacrylate was reacted with the carboxyl group of the acrylic acid unit in the acrylic polymer to obtain a side-chain double bond introduction type acrylic polymer having double bonds introduced to side chains, both the materials were reacted such that the amount of glycidyl methacrylate introduced was 60 mol (60% by mol) per 100 mol of the acrylic acid unit in the acrylic polymer; and 0.5 parts by weight of a trimethylolpropane-modified tolylene diisocyanate curing agent (Nippon Polyurethane Industry Co., Ltd.; CORONATE L-45E) were used as a polyisocyanate compound.

### (Comparative Example 1)

An adhesive tape was obtained in the same manner as in Example 6 except that: the step of washing the acrylic polymer was omitted; and 0.5 parts by weight of a trimethylolpropane-modified tolylene diisocyanate curing agent (Nippon Polyurethane Industry Co., Ltd.; CORONATE L-45E) were used as a polyisocyanate compound.

### (Comparative Example 2)

45 parts by weight of 2-ethylhexyl acrylate, 10 parts by weight of 2-hydroxyethyl acrylate, 40 parts by weight of methyl acrylate, 5.0 parts by weight of acrylic acid, and 0.03 parts by weight of an initiator (azobisisobutyronitrile) were copolymerized at 65°C for 24 hours in ethyl acetate to obtain a solution containing an acrylic polymer.

An adhesive tape was prepared in the same manner as in Example 1 except that: ultraviolet polymerizable urethane acrylate was separately added to the acrylic polymer; and the amounts of the curing agent and the initiator were also adjusted.

Each sample prepared as described above was subjected to evaluation tests on organic matter contamination, a contact angle, a molecular weight, 180° peel vs. silicon wafer adhesive strength, dicing, and pick-up as described below. The obtained results are summarized in Table 1 below.

### <Organic matter contamination>

The adhesive tape prepared as described above was attached to a prime wafer, left to stand for 24 hours, then irradiated with ultraviolet ray at 150 mJ/cm² from a high-pressure mercury lamp, and peeled. Then, a volatile organic component on the prime wafer surface was measured by TD-GC/MS. Measurement conditions for TD-GC/MS are given below.

### (Measurement conditions)

Sample pretreatment: An organic adsorbed substance on the wafer was recovered into a TENAX tube using the following apparatus.
Apparatus: "WA2560M" (manufactured by GL Sciences Inc.)
Heating conditions: Room temperature -> heating at approximately 25°C/min -> 400°C (kept for 15 min)
Adsorption conditions: Tenax tube (room temperature)
TD-GC/MS
Measurement apparatus: "TD2530" (manufactured by GL Sciences Inc.)
Agilent Technologies 7890B GC System
Agilent Technologies 5977A MSD
TENAX tube desorption temperature: 270°C
GC introduction method: Cold trap at -130°C, followed by heating at 270°C
Column: InertCap 1MS (length: 60 m, diam: 0.25 mm, film: 0.25 µm)
Carrier gas: He
Ionization method: EI method
GC heating conditions: 40°C (kept for 5 min) → heating at 10°C/min → 280°C (kept for 11 min)
Prime wafer used: 6 inch, particle: 0.3 µm ≤ 15 particles

### <Contact angle>

The adhesive tape prepared as described above was attached to a silicon wafer, left to stand under a condition of 23°C for 24 hours, then irradiated with ultraviolet ray at 150 mJ/cm² from a high-pressure mercury lamp, and peeled. Then, contact angle R₁ of the silicon wafer surface with respect to distilled water was measured by the liquid droplet method. Contact angle R₀ of the silicon wafer at the time of opening before attachment of the adhesive tape with respect to distilled water was also measured in the same manner as above, and the difference |R₀ - R₁| was calculated. Measurement conditions for the liquid droplet method are given below.
(Measurement conditions)
Water droplet: 3 mL
30 times/measurement (1 time/sec), a value obtained in the 30th run was adopted × n3

### <Weight-average molecular weight>

10 mg of the side-chain double bond introduction type acrylic polymer synthesized as described above was dissolved in 10 mL of tetrahydrofuran (THF, stabilizer-free, manufactured by Wako Pure Chemical Industries, Ltd.), and the solution was filtered through a membrane filter (made of PTFE, 0.50 µm) and subjected to analysis. Measurement conditions for the weight-average molecular weight are given below.

### (Analysis apparatus)

Gel permeation chromatograph analysis apparatus (DGU-20AC, etc., manufactured by Shimadzu Corp.)

### (Measurement conditions)

Standard: Shodex STANDARD (Type: SM-105, manufactured by Showa Denko K.K.)
Amount of sample introduced: 20 µL
Mobile phase: THF
Flow rate: 1 mL/min
Column: Shim-pack GPC-80M (300 mm × 8.0 mm I.D.)
Column temperature: 40°C
Detector: Differential refractive index detector (RID)

The content of component A1 having a weight-average molecular weight of 20000 or lower was determined by calculating the ratio of its area in a chromatogram at a retention time when the weight-average molecular weight reached 20000 or lower, from a calibration curve of molecular weights based on standard polystyrene with the area of the side-chain double bond introduction type acrylic polymer in a chromatogram defined as 100 area%.

### <Glass transition temperature>

The glass transition temperature of the polymer A was measured by differential scanning calorimetry (DSC) based on JIS K 7121.

### <180° peel strength>

The adhesive strength of the adhesive tape was measured in accordance with a method for measuring adhesive strength (method 1: testing method of peeling tapes and sheets by 180° with respect to stainless test plates) in JIS Z 0237 (2009). Specifically, the adhesive layer was pressure-bonded to a silicon wafer having a washed surface using a pressure bonding apparatus (roller mass: 2 kg), and 180° peel strength upon peeling of the adhesive tape by 180° relative to the silicon wafer was measured with a universal tensile tester (manufactured by Orientec Co., Ltd., Tensilon, model: RTG-1210) in an environment having a temperature of 23°C and a humidity of 50%.

### (Measurement conditions)

Measurement mode: Pulling
Pulling speed: 300 mm/min
Distance between chucks: 50 mm
Measurement sample width: 20 mm

### <Dicing step>

The adhesive tape prepared as described above was laminated to the back side of an 8 inch in diameter × 0.1 mm in thickness silicon wafer using a tape mounter apparatus equipped with a roller. Subsequently, the silicon wafer was diced into 0.49 mm × 0.3 mm semiconductor chips using a dicing blade. Main setting conditions for dicing are as given below.

### (Setting conditions)

Dicing apparatus: DAD341 manufactured by DISCO Corp.
Dicing blade: NBC-ZH2050-27HEEE manufactured by DISCO Corp.
Dicing blade rotation speed: 40,000 rpm
Dicing blade feed rate: 50 mm/sec
Cutting water temperature: 25°C
Amount of cutting water: 1.0 L/min

### <Pick-up step>

After the dicing step, the adhesive layer was cured by ultraviolet irradiation at 150 mJ/cm². Then, the semiconductor chips were picked up and peeled from the adhesive tape. Main setting conditions of pick-up is as given below.

### (Setting conditions)

Pick-up apparatus: CAP-300 II manufactured by Canon Machinery Inc.
Needle pin shape: 250 µm R
Needle pin push-up height: 0.5 mm
Expanding level: 8 mm
Push-up rate: 10,000 µm/sec

### <Pick-up yield>

A pick-up test was conducted as to pin heights from 0.1 mm to 1.5 mm by 0.1 mm at the time of pick-up. More specifically, the pick-up of 100 chips was attempted at each pin height, and the percentage of chips that were able to be picked up (pick-up yield) was confirmed on a pin height basis. Then, the minimum value of the pin height at which the pick-up yield of chips reached 95% or more is described in the table.

**[Table 1]**

| | | | Example | | | | | | | Comparative Example | |
|---|---|---|---|---|---|---|---|---|---|---|---|
| | | | 1 | 2 | 3 | 4 | 5 | 6 | 7 | 1 | 2 |
| Polymer A | Starting material | 2-Ethylhexyl acrylate [parts by weight] | 63 | - | - | 63 | 63 | 92 | 92 | 92 | 40 |
| | | 2-Hydroxyethyl acrylate [parts by weight] | 15 | 5 | 5 | 15 | 15 | - | - | - | 10 |
| | | Ethoxyethoxyethyl acrylate [parts by weight] | 22 | - | - | 22 | 22 | - | - | - | - |
| | | Butyl acrylate [parts by weight] | - | 67 | 67 | - | - | - | - | - | - |
| | | Methyl acrylate [parts by weight] | - | 28 | 28 | - | - | - | - | - | 45 |
| | | Acrylic acid [parts by weight] | - | - | - | - | - | 8 | 8 | 8 | 5 |
| | | Modifying agent: 2-methacryloyloxyethyl isocyanate [amount reacted: mol% (vs. reactive monomer unit)] | 50 | 70 | 70 | 30 | 50 | - | - | - | - |
| | | Modifying agent: glycidyl methacrylate [amount reacted: mol% (vs. reactive monomer unit)] | - | - | - | - | - | 80 | 60 | 80 | - |
| | Physical property | Ratio of unit having OH group [% by mol] | 11.0 | 2.0 | 2.0 | 15.0 | 11.0 | 14.0 | 11.0 | 14.0 | 10.0 |
| | | Glass transition temperature [°C] | -62 | -32 | -32 | -62 | -62 | -42 | -42 | -42 | -26 |
| | | Weight-average molecular weight (Mw) | 4.0×10⁵ | 6.0×10⁵ | 5.0× 10⁵ | 4.0×10⁵ | 8.0×10⁵ | 4.0×10⁵ | 4.0×10⁵ | 3.5x10⁵ | 2.0×10⁵ |
| | | Content of component 1 having Mw of 20000 or lower [Area%] | 4.0 | 3.5 | 8.0 | 5.0 | 6.0 | 15.0 | 13.0 | 20.0 | 55.0 |
| Resin composition | Composition | Polymer A [parts by weight] | 100 | 100 | 100 | 100 | 100 | 100 | 100 | 100 | 100 |
| | | Radical photoinitiator [parts by weight] | 2.10 | 2.10 | 2.10 | 2.10 | 2.10 | 2.10 | 2.10 | 2.10 | 7.00 |
| | | Curing agent [parts by weight] | 0.50 | 0.50 | 0.50 | 0.50 | 0.50 | 0.10 | 0.50 | 0.50 | 15.00 |
| | | Ultraviolet curable urethane acrylate [parts by weight] | - | - | - | - | - | - | - | - | 90.00 |
| | Physical property | Contact angle \|R₀-R₁\| [°] | 10.5 | 10.0 | 11.5 | 12.5 | 20.0 | 19.0 | 15.0 | 26.0 | 30.0 |
| | | 180° peel strength S before ultraviolet irradiation [N/20mm] | 5.4 | 8.0 | 7.5 | 7.0 | 1.8 | 10.8(Aggluti nation) | 12.0 | 8.0 | 12.0 |
| | Evaluation | Organic matter contamination, total amount of organic matter of volatile organic component [pg/cm2] | 400 | 300 | 650 | 850 | 8000 | 12000 | 1100 0 | 17000 | 19500 |
| | | Pin height at pick-up yield of 95% or more [mm] | 0.5 | 0.7 | 0.7 | 0.5 | 1.0 | 1.2 | 0.9 | 1.0 | 0.7 |

| | | | | | | | | | | | |
|---|---|---|---|---|---|---|---|---|---|---|---|
| *R₀ was 5.0. | | | | | | | | | | | |

### Industrial Applicability

The adhesive tape of the present invention has industrial applicability as a tape for semiconductor wafer processing, particularly, as an adhesive tape for use in a dicing step.

## Claims

1. An adhesive tape comprising
a base material layer and an adhesive layer disposed on the base material layer, wherein
the adhesive layer comprises a radical photoinitiator and a polymer A having a polymerizable carbon double bond, and
difference |R₀ - R₁| between a contact angle R₀ of silicon wafer surface with respect to water and a contact angle R₁ of the silicon wafer surface with respect to water after the adhesive layer is attached to the silicon wafer, left to stand for 24 hours, then irradiated with ultraviolet ray, and peeled, is 20° or less.

2. The adhesive tape according to claim 1, wherein
a content of component A1 having a weight-average molecular weight of 20000 or lower contained in the polymer A is 15 area% or less based on the total area of a chart of gel permeation chromatography.

3. The adhesive tape according to claim 1 or 2, wherein
180° peel strength of the adhesive layer to a silicon wafer before ultraviolet irradiation is 2.0 to 20.0 N/20 mm at 23°C.

4. The adhesive tape according to any one of claims 1 to 3, wherein
the polymer A has a hydroxy group.

5. The adhesive tape according to any one of claims 1 to 4, wherein
a weight-average molecular weight of the polymer A is 1.0 × 10⁵ to 2.0 × 10⁶.

6. The adhesive tape according to any one of claims 1 to 5, wherein
a glass transition temperature of the polymer A is - 80 to 23°C.

7. The adhesive tape according to any one of claims 1 to 6, wherein
the polymer A comprises a (meth)acrylic acid ester copolymer, and
the (meth)acrylic acid ester copolymer has a linear shape, a branched shape, or a cross-linked shape.

8. The adhesive tape according to any one of claims 1 to 7, wherein
the adhesive layer further comprises a curing agent.

9. The adhesive tape according to claim 8, wherein
the curing agent comprises an isocyanate compound.

10. The adhesive tape according to claim 9, wherein
the isocyanate compound comprises a difunctional or higher polyfunctional isocyanate compound.

11. The adhesive tape according to any one of claims 8 to 10, wherein
a content of the curing agent is 0.1 to 5.0 parts by weight per 100 parts by weight of the polymer A.

12. The adhesive tape according to any one of claims 1 to 11
for processing of a semiconductor wafer, a semiconductor device, or various semiconductor packages.

13. A processing method comprising:
a lamination step of laminating an adhesive tape according to any one of claims 1 to 12 with an adherend; and
a dicing step of singulating the adherend in a laminated state of the adhesive tape and the adherend, wherein
the adherend is a semiconductor wafer, a semiconductor device or various semiconductor packages.
